# EUROPEAN PATENT APPLICATION

(11) **EP 1 826 614 A1**
(43) Date of publication of application: **29.08.2007**
(21) Application number: 06003560.7
(22) Date of filing: 22.02.2006
(51) Int. Cl.: G03F 7/20

(54) **SLM height error compensation method**

(71) Applicant: MICRONIC LASER SYSTEMS AB, 183 03 Täby (SE); Fraunhofer-Gesellschaft zur Förderung der angewandten Forschung e.V., 80686 München (DE)
(72) Inventor: Sandström, Torbjörn, 435 43 Pixbo (SE); Duerr, Peter, 01099 Dresden (DE); Ljungblad, Ulric, 431 38 Mölndal (SE)

(57) **Abstract**

The present invention relates to a method for at least partly compensating height deviations (due to manufacturing imperfections) from one pixel to an adjoining pixel in at least one spatial light modulator (SLM) comprising a plurality of pixels in the form of tiltable mirrors with analog angle actuation, comprising the actions of determining a reference height for said tiltable mirrors, measuring a height of at least one mirror in said SLM, determining a deviation between said measured height of said mirror and said reference height, compensating the deviation by a height adjustment of at least one mirror.

## Description

### TECHNICAL FIELD

The present invention relates in general to techniques for obtaining improved images by compensation methods. In particular it relates to a method for compensating pixel height and/or phase errors in a Spatial Light Modulator (SLM).

### DESCRIPTION OF THE BACKGROUND ART

Lithographic production is useful for integrated circuits, masks, reticles, flat panel displays, micro-mechanical or micro-optical devices and packaging devices, e.g., lead frames and MCM's. Lithographic production may involve an optical system to image a master pattern from a computer-controlled reticle onto a workpiece. A suitable workpiece may comprise a layer sensitive to electromagnetic radiation, for example visible or non-visible light. An example of such a system is described in WO 9945435 with the same inventor and applicant as the present invention.

Said computer controlled reticle may be a spatial light modulator (SLM) comprising a one or two dimensional array of matrix of reflective movable micro mirrors. In general, these SLM's may be used for the formation of images in a variety of ways. The SLM may comprise many modulating elements or pixels, in some instances several millions of pixels.

Tilting mirrors with analog angle actuation may use a rasterizer that determines the best tilt angle for each mirror depending on the input pattern. The mirrors need to be controlled with high precision. Furthermore, the reflecting surface of the mirrors should preferably be as close to flat as possible.

Spatial Light Modulators may have height differences from one mirror to the next mirror. If this height difference is not small enough in comparison with the wavelength used to impinge on said SLM, said height difference may limit the resolution and accuracy available for their use in optical imaging, which may be a problem.

### SUMMARY OF THE INVENTION

Accordingly, it is an object of the present invention to improve the images formed using spatial light modulators by providing a method for compensation of pixels with height differences.

In a first embodiment, the invention provides a method for at least partly compensating height deviations (due to manufacturing imperfections) from one pixel to an adjoining pixel in at least one spatial light modulator (SLM) comprising a plurality of pixels in the form of tiltable micromirrors with analog angle actuation, comprising the actions of: determining a reference height for said tiltable mirrors, measuring a height of at least one mirror in said SLM, determining a deviation between said measured height of said mirror and said reference height, compensating the deviation by a height adjustment of at least one mirror.

Further embodiments, features, and advantages of the present inventions, as well as the structure and operation of the various embodiments of the present invention, are described in detail below with reference to the accompanying drawings.

### BRIEF DESCRIPTION OF THE DRAWINGS

For a more complete understanding of the present invention, and the advantages thereof, reference is now made to the following description taken in conjunction with the accompanying drawings, which are incorporated herein and form part of the specification, in which:
FIG. 1 illustrates a top view of a pixel in a Spatial light modulator (SLM) according to prior art.
FIG. 2 illustrates a top view of a pixel in a spatial light modulator according to an example embodiment of the present invention.
FIG. 3 illustrates a side view of a pixel according to figure 1.
FIG. 4 illustrates a side view of a pixel according to figure 2.
FIG. 5a illustrates a top view of a pixel according to an example embodiment according to the present invention.
FIG. 5b illustrates a top view of a pixel according to an example embodiment of the present invention.
FIG. 6a illustrates a side view of a plurality of pixels in a flat position with one pixel of a deviating height with respect to a reference plane.
FIG. 6b illustrates the pixels in fig. 6a in a deflected state with micromirrors according to prior art.
FIG. 6c illustrates the pixels in fig. 6a in a deflected state with micromirrors according to an example embodiment according to the present invention.
FIG. 6d illustrates an edge placement deviation for the example embodiment as depicted in figure 6c.
FIG. 7 illustrates the pixels in fig. 6a in a deflected state with micromirrors according to an alternative example embodiment according to the present invention.
FIG. 8 illustrates a top view of an example embodiment of a compensation scheme according to the present invention.
FIG. 9 illustrates an example embodiment of a flow chart for correcting pixel height differences according to the present invention.
FIG. 10a illustrates a first example embodiment according to the present invention of a mirror layout to implement figure 8.
FIG. 10b illustrates a second example embodiment according to the present invention of a mirror layout to implement figure 8.
FIG. 11 illustrates an example embodiment of an implementation of figure 10a.
FIG. 12a illustrates an example embodiment of how a deviating pixel height may be detected.
FIG. 12b illustrates an example embodiment of a flow chart for measuring pixel heights in an image.

The present invention will now be described with reference to the accompanying drawings. In the drawings, like reference numbers may indicate identical or functionally similar elements. Additionally, the left most digit(s) of a reference number may identify the drawing in which the reference number appears.

### DETAILED DESCRIPTION OF THE PREFFERED EMBODIMENTS

While specific configurations and arrangements are discussed, it should be understood that this is done for illustrative purpose only. A person skilled in the pertinent art will recognize that other configurations and arrangements can be used without departing from the scope of the present invention. It will be apparent to a person skilled in the pertinent art that this invention can also be employed in a variety of other applications.

Workpiece in the description below is meant to mean one of the group of: substrate for producing semiconductors (direct write), mask substrate, reticle substrate.

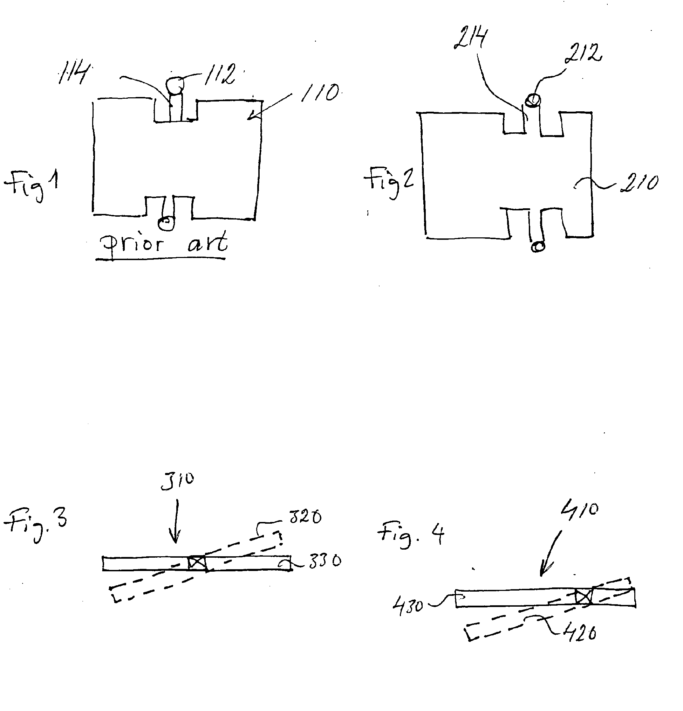

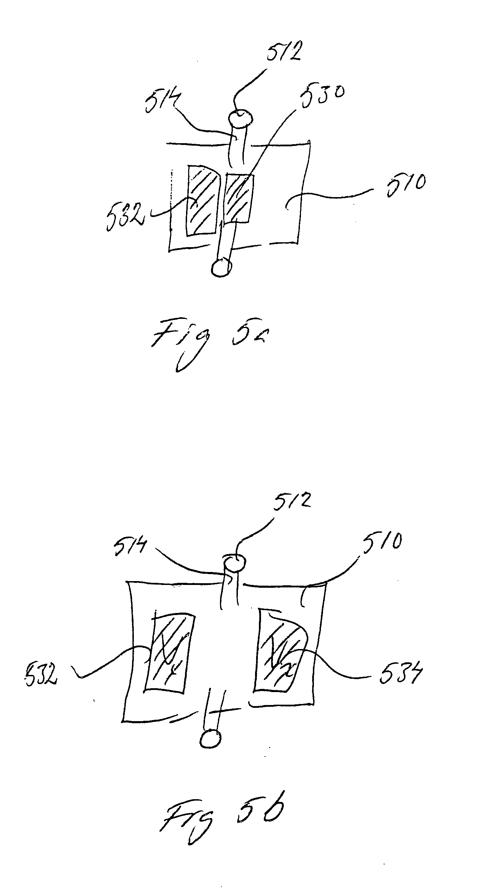

Figure 1 illustrates a top view of an example embodiment of a pixel in a spatial light modulator (SLM) according to prior art. The pixel comprises a mirror 110, a post 112 and a hinge 114. The hinge 114 connects the mirror to the post. The mirror is deflectable/tiltable around a deflection/tilting axis defined by said hinge. The hinge is provided in a symmetric position, i.e., the tilting axis and a symmetry axis of a top surface of the mirror is at the same position.

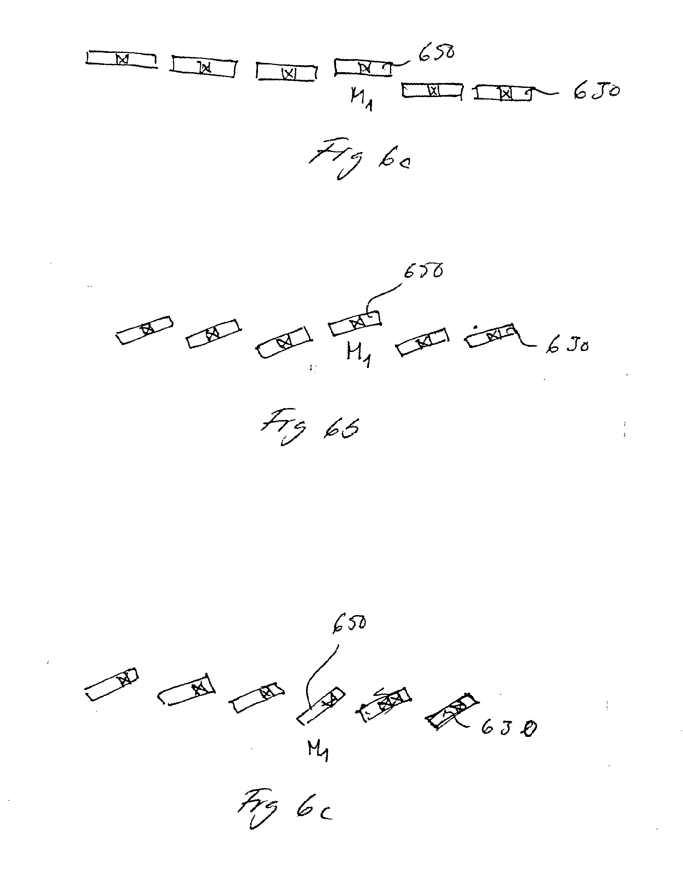

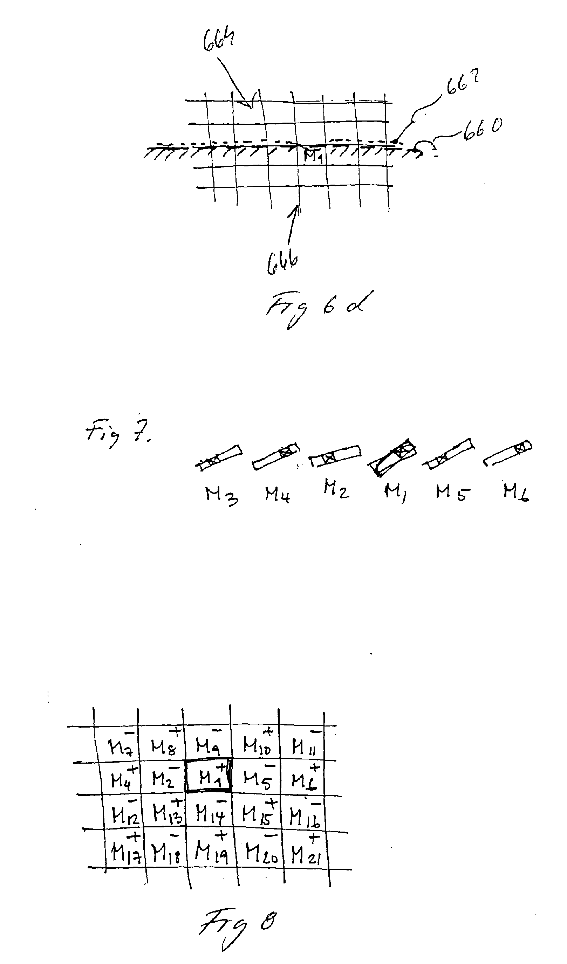

Figure 2 illustrates a top view of a first example embodiment of a pixel in a spatial light modulator according to the present invention. The pixel comprises a mirror 210, a post 212 and a hinge 214. The hinge is provided in a non-symmetric position, i.e., the tilting axis and the symmetry axis of the top surface of the mirror do not coincide with each other. An asymmetric hinge for a deflectable mirror with said hinge as the deflection axis will result in a simultaneous tilting and pistoning action, i.e., when the mirror is deflected the centre of gravity of the mirror will move perpendicular to the tilting axis.

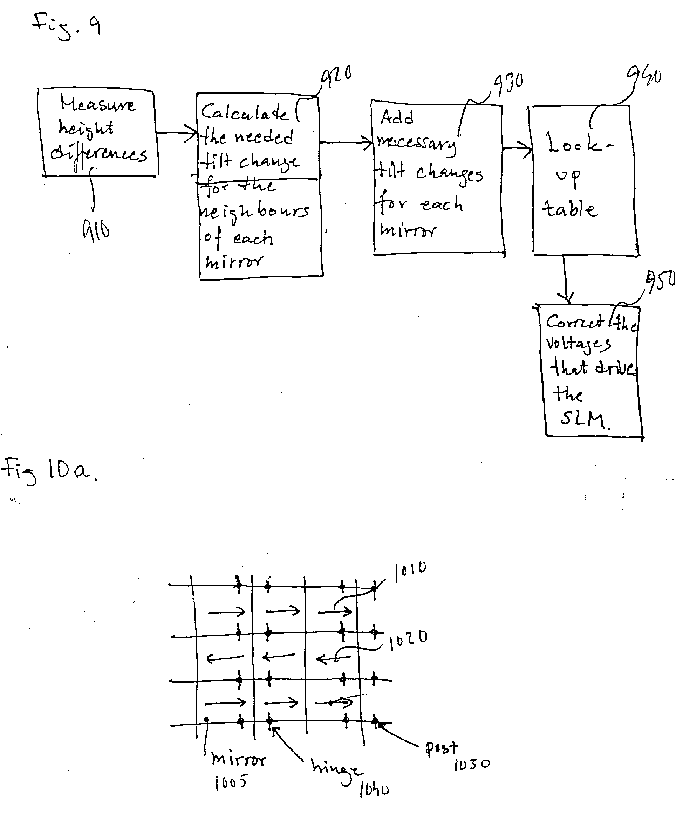

Figure 3 illustrates a side view of a pixel according to figure 1. Dashed lines represent the mirror 310 in a deflected state 320 and solid lines represent the mirror 310 in a non-deflected state 330. As can be seen from figure 3, a centre of gravity of said mirror 310 is not moving upwards or downwards when deflecting said mirror 310, i.e., it is a pure deflection since a deflection axis coincides with the symmetry axis of the top surface of said mirror 310.

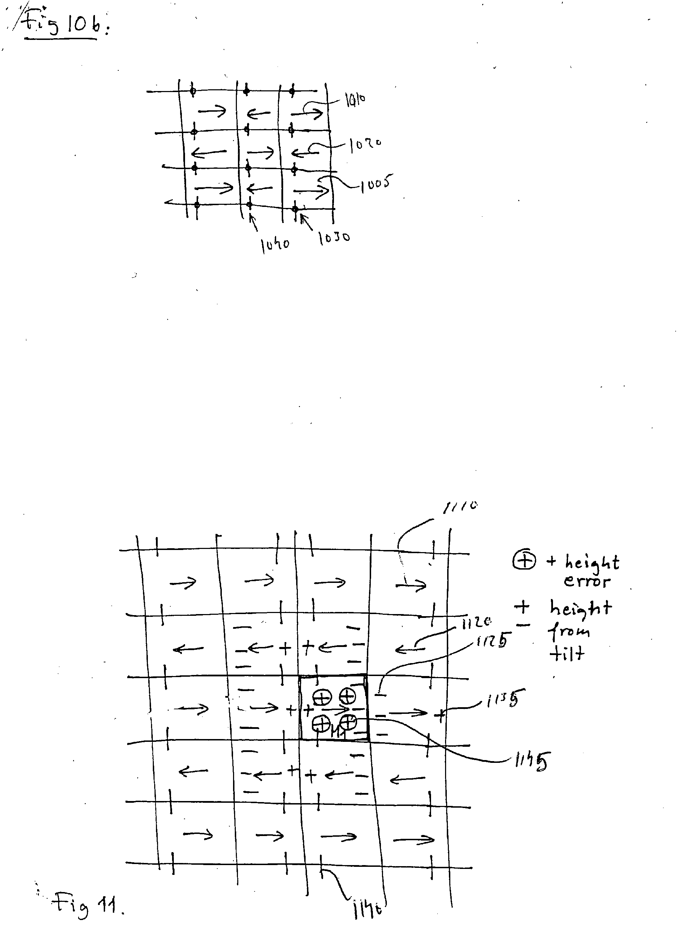

Figure 4 illustrates a side view of a pixel according to figure 2. Dashed lines represent the mirror 410 in a deflected state 420 and solid lines represent the mirror 410 in a non-deflected state 430. As can be seen from figure 4, a centre of gravity of said mirror 410 is moving upwards or downwards (perpendicular to a deflection axis) when deflecting said mirror 410, i.e., it is a combined tilting and pistoning action since the deflection axis coincides with a symmetry axis of the top surface of said mirror 410.

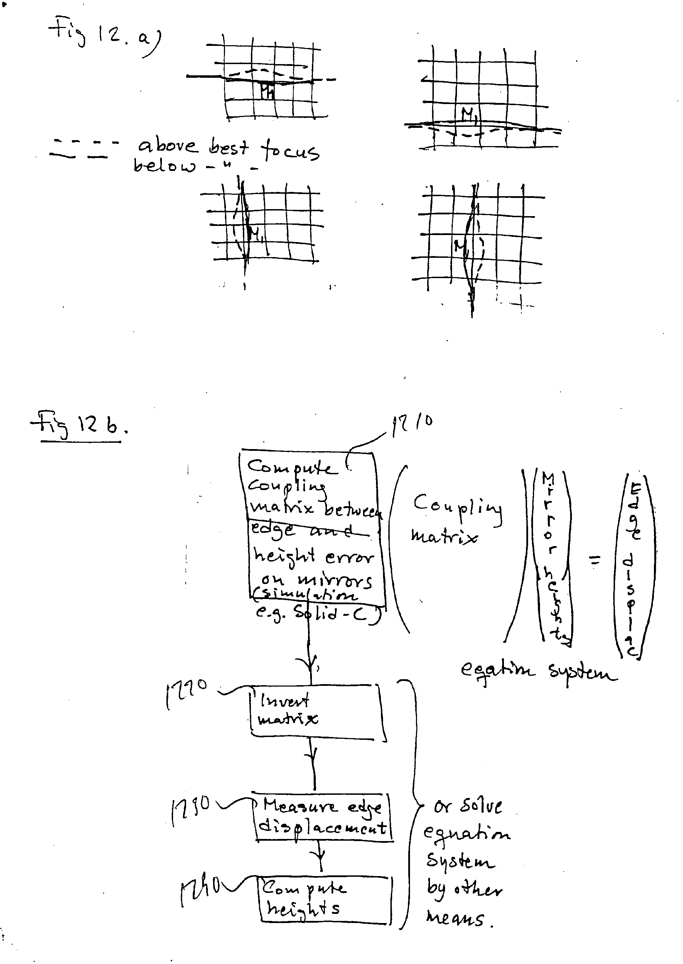

Figure 5a illustrates a top view of a pixel in a spatial light modulator according to a second example embodiment according to the present invention. The pixel comprises a mirror 510, a post 512, a hinge 514, a first electrode 530 and a second electrode 532. The hinge 514 connects the mirror 510 to the post 512. The mirror 510 is deflectable/tiltable around a deflection/tilting axis defined by said hinge 514. The hinge 514 is provided in a symmetric position, i.e., the tilting axis and a symmetry axis of the top surface of the mirror 510 coincide with each other. The first electrode 530 is provided beneath the tilting axis of said mirror 510. When applying a first voltage to said first electrode 530 and a second voltage to the mirror 510, said first and second voltages have to be unequal in order to create an electrostatic attractive force between said first electrode and said mirror, said mirror will be electrostatically attracted to said first electrode and move in a pistoning action, i.e., it will be a parallel displacement of the whole mirror 510 towards the first electrode 530. For deflecting said mirror 510, a first voltage is applied to said second electrode 532 and a second voltage is applied to the mirror 510, said first and second voltages have to be unequal in order to create an electrostatic attractive force between said second electrode 532 and said mirror 510. Since said second electrode 532 is arranged laterally displaced from the symmetry axis and tilting axis of the mirror 510, said electrostatic attractive force is creating a deflecting action of the mirror 510 around said tilting axis.

Figure 5b illustrates a top view of a pixel in a spatial light modulator according to a third example embodiment according to the present invention. The pixel comprises a mirror 510, a post 512, a hinge 514, a first electrode 532 and a second electrode 534. The hinge 514 connects the mirror 510 to the post 512. The mirror 510 is deflectable/tiltable around a deflection/tilting axis defined by said hinge 514. The hinge 514 is provided in a symmetric position, i.e., the tilting axis and a symmetry axis of the top surface of the mirror coincide with each other. When applying a first voltage to said first electrode 532, a second voltage to said second electrode 534 and a third voltage to the mirror 510, said mirror will be simultaneously electrostatically attracted to said first and second electrodes and move in a pure pistoning action, i.e., it will be a parallel displacement of the whole mirror 510 towards the first electrode 532 and said second electrode if said first and second voltages are equal and said third voltage is different to said first and second voltages.

For deflecting said mirror 510 a first voltage is applied to said first electrode 532, a second voltage is applied to the second electrode and a third voltage is applied to the mirror 510. Said first and second voltages have to be unequal in order to create a deflection type action of the mirror. Depending of the voltage difference between the mirror and the first electrode and between the mirror and the second electrode said mirror may be steered to be deflected in a clockwise manner or an anti-clockwise manner by suitable voltage differences between the mirror and the first and second electrodes.

Figure 6a illustrates a side view of six pixels in a flat position with one pixel 650 of a deviating height with respect to the other pixels 630. All pixels represent a fully on position, i.e., white pixels. However, the pixel 650 with the deviating height has another phase with respect to the other pixels 630. A bump in the phase map, i.e., a pixel with a deviating height, makes the light beam asymmetric in a wafer/mask blank plane.

Figure 6b illustrates the pixels in fig. 6a in a deflected state. In figure 6b the micromirrors have a symmetrically arranged tilting axis according to prior art. The pixel with the deviating height 650 is still at another height compared to the other pixels 630. Tilting mirrors with symmetrically arranged tilting axis have a constant phase regardless of how it is tilted. A pixel with analog angle actuation will have a constant phase for all its grey values. Prior art calibration methods will not (and cannot) remove said phase deviation for prior art pixel configurations. A feature edge defined by a mirror will shift through focus if said mirror has a deviating height with respect to a reference height. Alternatively speaking, a pointing vector will be non-normal in focus for a mirror with a deviating height with respect to a reference plane.

FIG. 6c illustrates the pixels in fig. 6a in a deflected state. In figure 6c the mirrors have a non-symmetrically arranged tilting axis according to en example embodiment of the present invention. In the depicted illustration in figure 6c, pixels 630 are set to a predetermined grey value, i.e., any deflection state between fully black or fully white. Pixel 650 is set to a somewhat darker deflection state, i.e., a larger tilt to compensate its deviating height compared to pixels 630. Since the asymmetric hinge gives a simultaneous tilting and pistoning action, said larger tilt will make up for an original phase difference in non-deflected state. Pixel 650 have a different analog tilting angle in figure 6c and its asymmetric hinge moves an average height of the mirror to the same average height as its neighbors. The difference in analog tilting angle may give an error in edge placement in best focus. A better stability through focus (= same average phase on all mirrors) is bought by sacrificing the edge placement at best focus, see figure 6d.

In figure 6d an upper portion 664 is bright (flat pixels) and a lower portion 666 is dark (deflected pixels). A feature edge 662 is dividing said portions 664, 666. Pixels in said feature edge may be set according to figure 6c. Feature edge 662, represented in figure 6d with a dashed line is having a bump M1 due to the different tilting angle of pixel 650. A Feature edge in data is represented in figure 6d with a solid line 660 which is flat.

Figure 7 illustrates the pixels in fig. 6a in a deflected state with mirrors according to an alternative example embodiment according to the present invention. In this alternative example embodiment a neighbor to M1 is deflected in an opposite direction. The neighbors are asymmetric in an opposite sense, i.e., the pistoning effect has opposite sign. M2 has a smaller tilt and gets a lower height, M1 has a higher tilt and gets also a lower height. These height differences together correct for the built in positive height error in M1. Because of the limited resolution, an intentional height imposed on M1 and M2 fully correct for the built in height error on M1. If the resolution was higher, there would be an edge placement error from M1 and the opposite error from M2 displaced by one unit. But projection optics used together with analog angle actuated mirrors may have a resolution that cannot resolve a plus and minus edge error so close together and no edge error is printed. The resolution in such system may typically not resolve single pixels. M1 and M2 have corrected for the height error in M1 with no penalty in edge placement. The resolution condition is that the frequency component with one period per two mirrors is blocked by a spatial (Fourier) filtering in the system aperture. The example in figure 7 is asymmetric, M1 is corrected by the mirror to the left of M1, i.e., M2. It is desirable to make all operations left-right symmetrical and preferably symmetrical between horizontal and vertical directions.

Figure 8 illustrates a compensation scheme which is symmetrical both left to right and horizontal and vertical. In figure 8 M1 is compensated by a combination of intentional tilt errors on M9, M2, M5, M14 and M1. It is also possible to tilt M8, M10, M13 and M15, although with less effect, and all or only some of the mirrors can be used. In figure 8 a + sign indicates some coupling between tilt and pistoning and a - sign indicates an opposite coupling. Said + sign may represent an increase or a decrease in pistoning action, i.e., the center of gravity may move up or down relative to a given position. Actually, coupling between tilt and pistoning is proportional to abs(tilt).

Figure 9 illustrates an example embodiment of a flow chart for correcting pixel height differences according to the present invention. In a first step 910 height differences are measured for at least two pixels in the SLM. Pixel height may be determined by printing a test pattern on a CCD camera. Said test pattern is printed using different focus setups. Said test pattern may for instance be a line pattern. The edge of at least one line is computed from the CCD image. If the edge moves through focus this may indicate a height error adjacent to the edge, see figure 12.

Another way of finding height errors in pixels in an SLM may be by using interferometry, i.e., individual pixels height are determined by interferometry according to well known principles such as white light interfermometry, shearing interferometry or phase-shifting interferometry.

Yet another way of determining the height errors may be by using wavefront sensing technique, for example according to Hartman-Shack, knife edge or Schlieren methods.

The height may be determined at manufacturing of the SLM and used through-out its life or it may be measured in situ in a lithography system where the SLM may be used as a pattern generator, attenuator or as another optical device.

In a second step 920 a calculation of the needed tilt change for the neighbors of each mirror is determined. In a previous example embodiment, an elimination/compensation of the height error of a pixel were performed by altering the height of the pixel with a deviating height only. In this alternative example embodiment said elimination/compensation of the height error is distributed between the mirror with a deviating height and at least one of its neighboring mirrors. The following figures will illustrate how that may be accomplished.

In a third step 930 said necessary tilt changes are added for each mirror. In a fourth step 940 said tilt changes for each mirror are stored in a look-up table. This look-up table may be used whenever a new pattern is going to be set on said SLM. The Look up table may be static, i.e., it may use original measurement data or it may be a table that is constantly updated with information about new pixel heights in the SLM during or operation.

In a fifth step said information in said look-up table is used when correcting voltages that is going to drive individual pixels in an SLM. Voltages may also be stored in a look up table where each deflection state may correspond to a specific voltage for each mirror.

Figure 10a a first example embodiment according to the present invention of a mirror layout to implement figure 8. Figure 10a illustrates an example embodiment in which each adjoining mirror 1005 has an opposite pistoning action. Every second row of pixels are deflected clockwise, which is indicated by an arrow to the right 1010 and the rest of the rows are deflected anti-clockwise, which is indicated by arrows to the left 1020. Every second column of pixels has a post 1030 for a hinge 1040 arranged to the right of a mirror symmetry axis and the rest of the columns have posts to the left of the symmetry axis of the mirror.

Figure 10b illustrates a second example embodiment according to the present invention of a mirror layout to implement figure 8. Here, each mirror has the post 1030 for the hinge 1040 arranged to the right of the symmetry axis of the top surface of the mirror 1005. Adjoining mirrors have an opposite direction of deflection, i.e., if one particular pixel/mirror is deflected clockwise then the adjoining pixels/mirrors are deflected anti-clockwise.

Figure 11 illustrates an example embodiment of an implementation of figure 10a. In the previous illustrated example embodiment of the present invention, tilts of neighbors is performed so that the most close areas to the faulty mirror M1 get a height opposite to said error in M1, i.e., if the height error is positive then a compensation in height of most closely neighbors may be negative, the compensation in height of next most close neighbors may be positive and so on. In figure 11, a positive sign within a circle 1145 denotes a positive height error, i.e., a too high mirror compared to a given reference height. Arrows 1110, 1120 (to the left or to the right) indicate a tilting direction, arrow to the right indicate clockwise tilting and arrow to the left indicate anti-clockwise tilting. The position of the hinge is denoted by 1140. Bare signs 1125, 1135 indicate height from tilt. In figure 11 mirror M1 is too high relative to a reference height. This is compensated by tilting said mirror M1 a little bit more, i.e., lowering its center of gravity (more negative phase) indicated by triple negative signs and only one positive sign in mirror M1. The adjoining mirrors to M1 are also compensating for the height error in M1. The center of gravity of said adjoining mirrors are also lowered compared to its intended value if M1 would not have been at a deviating height. Here again said lowering of the center of gravity of the adjoining mirrors are indicated by a triple negative sign and only one positive sign. In this alternative example embodiment the compensation of the height error in mirror M1 is spread among said mirror and at least one of its closest neighbors. In one example embodiment said compensation could be performed by using said mirror with a deviating height and only one of its closest neighbors. In another example embodiment two closest neighbors are used, which could be one to the left and one to the right or one above and one below. In yet another example embodiment all closest neighbors are used for said compensation. The degree of compensation of the neighbor mirrors may be equal.

Figure 12a illustrates how a pixel with a height error may be detected by detecting edges of straight lines or straight feature edges at different locations and different direction. In the upper left corner in figure 12a a horizontal line is used to detect a pixel M1 with a deviating height. Depending on a focus setting the height deviation in said line will appear differently. In figure 12a a pixel with a deviating height is denoted with M1. Dashed lines illustrate when the focus setting is above best focus, i.e., too far away from an object, and solid line illustrate when the focus setting is below best focus, i.e., too close to the object. By using this knowledge it is possible to localize a pixel with a deviating height relative to a reference pixel or a reference plane. The four different line edges or feature edges illustrated in figure 12a may precisely determine the location of the deviating pixel M1.

In figure 12b it is illustrated an example embodiment of how heights may be measured in an image. In a first step a coupling matrix is computed. Said matrix couples the mirror heights to edge displacements. Said matrix may be computed by using simulation tool Solid-C or equivalent methods.

In a second step said matrix is inverted according to well known methods.

In a third step edge displacements are measured. The measurement may be performed in a CCD image which may be similar to the pictures as illustrated in figure 12a.

In a fourth step the mirror height are computed by using the information about the coupling matrix and said measured edge displacements.

In reality the SLM may comprise several millions of pixels but for reasons of clarity an SLM with few pixels are illustrated. A pixel with deviating height may be too low or too high with respect to a predefined reference plane.

The pixels in the SLM may be operated in an analog manner. Micro mirror pixels are typically operated electrostatically. The bigger the potential difference between said address electrode and said mirror element the more said mirror might deflect. A given potential difference corresponds to a given deflection for a given mirror and therefore the deflection can be set to a plurality of states between a non deflected state, i.e., the mirror is electrostatically un-attracted, and a fully deflected state.

The CCD-camera may for example be a camera from Kodak ® KAF 1600 with approximately 1000*1600 pixels and sensitivity for the wavelength used, e.g. 248nm or 197nm. Typically this involves converting the radiation to visible light by a fluorescent dye, but camera chips which are directly sensitive to short wavelength, e.g. 248 nm are also available.

Thus, although there has been disclosed to this point particular embodiments of the apparatus for patterning a work piece, it is not intended that such specific references be considered as limitations upon the scope of this invention except in-so-far as set forth in the following claims. Furthermore, having described the invention in connection with certain specific embodiments thereof, it is to be understood that further modifications may suggest themselves to those skilled in the art, it is intended to cover all such modifications as fall within the scope of the appended claims.

## Claims

1. A method for at least partly compensating height deviations (due to manufacturing imperfections) from one pixel to an adjoining pixel in at least one spatial light modulator (SLM) comprising a plurality of pixels in the form of tiltable micromirrors with analog angle actuation, comprising the actions of:
- determining a reference height for said tiltable mirrors,
- measuring a height of at least one mirror in said SLM,
- determining a deviation between said measured height of said mirror and said reference height,
- compensating the deviation by a height adjustment of at least one mirror.

2. The method according to claim 1, wherein said mirrors have a combined tilting and pistoning action.

3. The method according to claim 1, wherein said compensation for said height deviation is performed by using the mirror with a deviating height.

4. The method according to claim 2, wherein said combined pistoning and tilting action is performed by an asymmetric arranged hinge defining a tilting axis.

5. The method according to claim 3, wherein said compensation is performed by using at least one adjoining mirror to the mirror with a deviating height.

6. The method according to claim 5, wherein a degree of compensation is equal for adjoining mirrors.

7. The method according to claim 6, wherein said adjoining mirrors which are used for compensation are evenly distributed around a symmetry axis of said deviating mirror.

8. The method according to claim 7, wherein a center of gravity of the adjoining mirrors, which are used for compensation, are moved in a same compensation direction as the center of gravity of the mirror with a deviating height.

9. The method according to claim 1, wherein said pistoning and tilting action is performed by providing an electrode beneath a hinge defining a tilting axis of said mirror.

10. The method according to claim 1, wherein said pistoning and tilting action are performed by providing electrostatic attraction on both sides of a hinge defining a tilting axis of said mirror.

11. The method according to claim 4, wherein at least two adjoining mirrors have oppositely arranged hinges.

12. The method according to claim 4, wherein at least two adjoining mirrors are deflected in an opposite direction.
